# EUROPÄISCHE PATENTSCHRIFT

(11) **EP 2 947 702 B1**
(45) Veröffentlichungstag und Bekanntmachung des Hinweises auf die Patenterteilung: **20.03.2019**
(21) Anmeldenummer: 14001785.6
(22) Anmeldetag: 21.05.2014
(51) Int. Cl.: H01L 31/0687

(54) **Solarzellenstapel**
Solar cell stack
Empilement de cellules solaires

(43) Veröffentlichungstag der Anmeldung: 25.11.2015
(73) Patentinhaber: AZUR SPACE Solar Power GmbH, 74072 Heilbronn (DE)
(72) Erfinder: Guter, Wolfgang, 70190 Stuttgart (DE)
(74) Vertreter: Koch Müller Patentanwaltsgesellschaft mbH

(56) Entgegenhaltungen:
- EP-A1- 2 610 924
- US-A1- 2009 229 659
- US-A1- 2012 227 797
- V. KLINGER ET AL: "Determination of hardness and Young's modulus for important III-V compound semiconductors", THIN SOLID FILMS, Bd. 548, 29. August 2013 (2013-08-29), Seiten 358-365, XP055156264, ISSN: 0040-6090, DOI: 10.1016/j.tsf.2013.08.079
- ZAKARIA A ET AL: "Comparison of arsenide and phosphide based graded buffer layers used in inverted metamorphic solar cells", JOURNAL OF APPLIED PHYSICS, AMERICAN INSTITUTE OF PHYSICS, US, Bd. 112, Nr. 2, 15. Juli 2012 (2012-07-15) , Seiten 24907-24907, XP012166281, ISSN: 0021-8979, DOI: 10.1063/1.4737788 [gefunden am 2012-07-23]
- HECTOR COTAL ET AL: "III-V multijunction solar cells for concentrating photovoltaics", ENERGY & ENVIRONMENTAL SCIENCE, Bd. 2, Nr. 2, 10. Dezember 2008 (2008-12-10), Seite 174, XP055033873, ISSN: 1754-5692, DOI: 10.1039/b809257e

## Beschreibung

Die Erfindung betrifft einen Solarzellenstapel gemäß dem Oberbegriff des Patentanspruchs 1.

Bei der Epitaxie von III-V Mehrfach-Solarzellen werden so genannte metamorphe Puffer verwendet, um auf den metamorphen Puffern Halbleiterschichten aus Materialien mit einer anderen Gitterkonstanten als die des Substrates bzw. von unterhalb des Puffers liegenden Schichten mit hoher Qualität abzuscheiden. Durch den metamorphen Puffer wird ein so genanntes virtuelles Substrat mit anderer Gitterkonstante als die des ursprünglichen Substrates gebildet. Hierdurch lässt sich der Spielraum für die Wahl von Materialien beispielsweise für die verschiedenen Elemente einer Mehrfach-Solarzelle vergrößern und den Wirkungsgrad der Mehrfach-Solarzelle erhöhen.

Es ist wünschenswert, dass die Gitterkonstante des metamorphen Puffers während der Herstellung im Allgemeinen vergrößert wird. Hierdurch sind die meisten Schichten des Puffers kompressiv verspannt, wobei sich in einem Vergleich zu einem tensil verspannten Puffer die Versetzungen homogener ausbilden und insbesondere weniger Risse entstehen. Außerdem ist es wünschenswert, dass alle Schichten des metamorphen Puffers für Licht bestimmter Wellenlängen transparent sind, so dass sich das Licht in den weiteren Solarzellen zur photoelektrischen Energiekonversion nutzen lässt.

Aus A. Zakaria, Richard R. King, M. Jackson, and M. S. Goorsky; Comparison of arsenide and phosphide based graded buffer layers used in inverted metamorphic solar cells; J. Appl. Phys. 112, 024907 (2012) sind mehrere Solarzellenstapel mit jeweils einem metamorphen Puffer bekannt. Des Weiteren sind aus US 2013 / 0312818 A1 Solarzellenstapel mit metamorphen Puffern wie in der vorliegenden Fig. 4 wiedergegeben, bekannt. Auch in W. Guter, J. Schöne, S. P. Philipps, M. Steiner, G. Siefer, A. Wekkeli, E. Welser, E. Olivia, A. Bett und F. Dimroth; Current-matched triple-junction solar cell reaching 41.1 % conversion efficiency under concentrated sunlight; Applied Physics Letters 94, 223504, 2009; sind metamorphe Solarzellenstapel offenbart. Auch sind aus der EP 2 610 924 A1, der US 2012 / 227 797 A1 und der US 2009 / 229 659 A1 weitere metamorphe Puffer bekannt.

Weitere Solarzellenstapel mit metamorphen Puffern sind in J. Schöne, "Kontrolle von Spannungsrelaxation und Defektbildung in metamorphen III-V Halbleiterheterostrukturen für hocheffiziente Halbleiter-Solarzellen, Dissertation 2009, Technische Fakultät Kiel, offenbart.

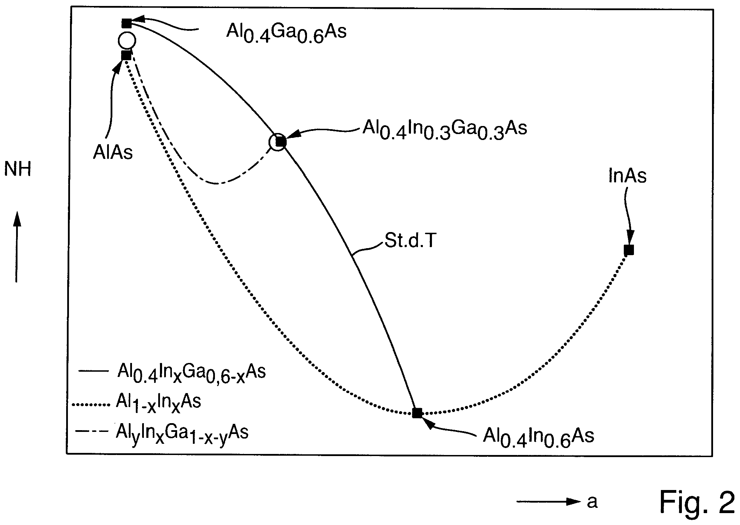

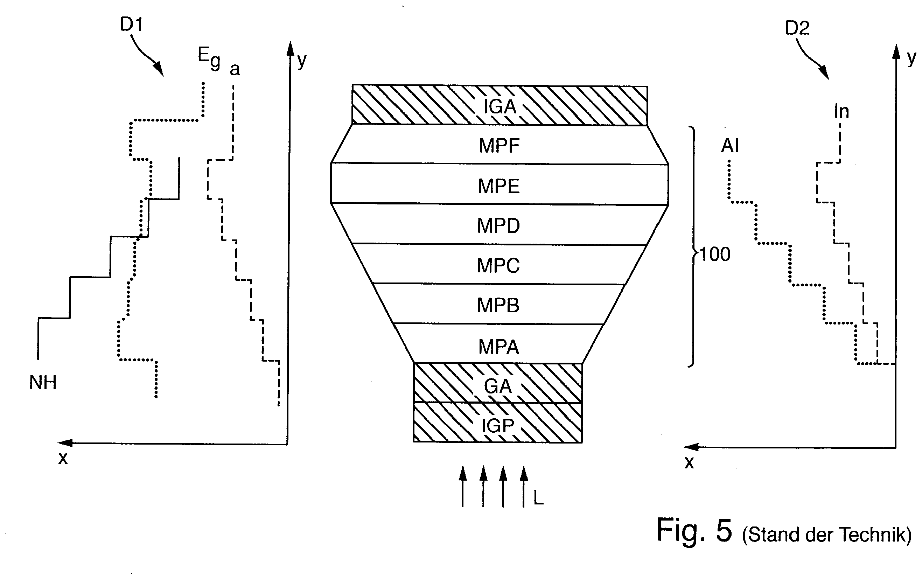

Ferner ist es bei den metamorphen Puffern wünschenswert, Gitterverspannungen durch Bildung von Versetzungen oder anderen Kristalldefekten bereits in den Puffern abzubauen, wobei die Kristalldefekte möglichst in dem Puffer lokalisiert werden. Insbesondere sollen Fadenversetzungen daran gehindert werden, in andere Teile des Halbleiterschichtstapels vorzudringen. Hierzu ist es bevorzugt in den metamorphen Puffern die Härte der Pufferschichten mit der Gitterkonstante ansteigen zu lassen, um insbesondere die Ausbreitung von Versetzungen in darüber liegende Schichten zu reduzieren und /oder die Relaxation von darüber liegenden Schichten zu erschweren. Im Unterschied hierzu wird von V. Klinger, T. Roesener, G. Lorenz, M. Petzold und F. Dimroth; Elastische und plastische Eigenschaften von III-V Halbleitern für metamorphe Pufferstrukturen; 27. DGKK Workshop - Epitaxie von III/V -Halbleitern - Erlangen, 6./7. Dezember 2012; offenbart, dass für einen metamorphen Puffer gemäß der Figur 5 der vorliegenden Anmeldung aus der quaternären Verbindung Al0.4InxGa0.6-xAs (0<x<0.6) bei dem das Element Gallium sukzessive durch Indium ersetzt wird, die Gitterkonstante mit dem In-Gehalt ansteigt, während die Nanohärte abnimmt, dargestellt als durchgezogene Linie in der vorliegenden Figur 2.

Vor diesem Hintergrund besteht die Aufgabe der Erfindung darin, eine Vorrichtung anzugeben, die den Stand der Technik weiterbildet.

Die Aufgabe wird durch einen Solarzellenstapel mit den Merkmalen des Patentanspruchs 1 gelöst. Vorteilhafte Ausgestaltungen der Erfindung sind Gegenstand von Unteransprüchen.

Gemäß Gegenstand der Erfindung wird ein Solarzellenstapel bereitgestellt, mit einer ersten Halbleiter-Solarzelle, wobei die erste Halbleiter-Solarzelle einen p-n Übergang aus einem ersten Material mit einer ersten Gitterkonstanten aufweist, und mit einer zweiten Halbleiter-Solarzelle, wobei die zweite Halbleiter-Solarzelle einen p-n Übergang aus einem zweiten Material mit einer zweiten Gitterkonstanten aufweist, und wobei die erste Gitterkonstante kleiner als die zweite Gitterkonstante ist, und der Solarzellenstapel einen metamorphen Puffer aufweist, wobei der metamorphe Puffer eine Abfolge von einer ersten unteren AlInGaAs- oder AlInGaP-Schicht und einer zweiten mittleren AlInGaAs- oder AlInGaP-Schicht und einer dritten oberen AlInGaAs- oder AlInGaP-Schicht umfasst, und der metamorphe Puffer zwischen der ersten Halbleiter-Solarzelle und der zweiten Halbleiter-Solarzelle ausgebildet ist, wobei bei dem metamorphen Puffer entlang der Dickenerstreckung, d.h. entlang der Abfolge der Schichten des metamorphen Puffers, die Gitterkonstante sich ändert, und wobei zwischen wenigstens zwei Schichten des metamorphen Puffers die Gitterkonstante und der In-Gehalt zunimmt und der Al-Gehalt abnimmt. Es versteht sich, dass die drei Schichten unmittelbar aufeinanderfolgen oder dass sowohl zwischen der ersten Schicht und zweien Schicht und/oder zwischen der zweiten Schicht und der dritten Schicht weitere Schichten ausgebildet sind.

Es sei angemerkt, dass die Anzahl der Schichten der metamorphen Puffer wenigstens drei beträgt, jedoch je nach Anwendungsfall auch eine Anzahl von sechs Schichten oder bis zu dreißig oder mehr einzelne Schichten herstellbar sind. Des Weiteren sei angemerkt, dass die einzelnen Schichten der metamorphen Puffer im Allgemeinen dünn, vorzugsweise unterhalb 600 nm, höchst vorzugsweise unterhalb 300 nm ausgebildet sind. Des Weiteren bezieht sich die Gitterkonstante eines Materials immer auf den unverspannten Zustand. Insbesondere sind grundsätzlich an der Fügungsstelle zwischen zwei Schichten die lateralen (in-plane) Gitterkonstanten der beiden aneinanderliegenden Schichten nahezu identisch, während sich die vertikalen (out-ofplane) Gitterkonstanten und die Gitterkonstante im unverspannten Fall unterscheiden.

Ein Vorteil der erfindungsgemäßen Vorrichtung ist es, dass mittels des hohen Al-Gehaltes in der ersten unteren Schicht des metamorphen Puffers trotz einer weiter ansteigenden Gitterkonstante im Vergleich mit der darunterliegenden Schicht und der darüberliegenden Schicht zu einer Ausbildung von einer besonders weichen Schicht, d.h. einer Schicht mit einer geringen Nanohärte, innerhalb des Puffers kommt. Mit dem Begriff der Nanohärte wird nachfolgend die Härte der jeweiligen Schicht des Puffers bezeichnet. Es sei angemerkt, dass die Nanohärte in erster Näherung innerhalb der einzelnen Schicht als homogen und konstant betrachtet wird. Des Weiteren sei angemerkt, dass mit dem Begriff unterer erster Schicht, diejenige Schicht bezeichnet wird, die der ersten Halbleiter-Solarzelle am nächsten ausgebildet ist. Mit der Ausbildung einer weichen Schicht wird eine Bildung von Fehlanpassungsversetzungen in der ersten unteren Schicht erleichtert. Untersuchungen haben gezeigt, dass sich in der ersten Schicht die Versetzungen bevorzugt ausbilden und in der ersten Schicht verbleiben und nicht zu den unterhalb und / oder zu den oberhalb liegenden aktiven Schichten der Halbleiter-Solarzellen vordringen. Hierdurch werden eine unerwünschte Reduktion der Ladungsträgerdiffusionslängen in den aktiven Schichten und eine Verringerung des Wirkungsgrades der Halbleiter-Solarzellen in dem Solarzellenstapel verhindert. Anders ausgedrückt wird mit der Ausbildung der ersten Schicht mit dem im Vergleich zu den anderen Schichten des metamorphen Puffers höchsten Aluminium-Gehalt und auch in einem Vergleich zu den unmittelbar in einer stoffschlüssigen Verbindung mit dem metamorphen Puffer stehenden weiteren Schichten in der ersten Schicht eine Art "Sollbruchstelle" eingeführt, indem die erste Schicht besonderes weich im Vergleich zu den umgebenden Schichten ausgebildet ist.

Wenn die Härte der Halbleiterschichten in dem metamorphen Puffer erfindungsgemäß mit der Gitterkonstanten ansteigt, wird wiederholt unterdrückt, dass Schichten mit größerer Gitterkonstante und größerer Härte relaxieren, bevor Schichten mit kleinerer Gitterkonstante und kleinerer Härte nahezu vollständig relaxiert sind. Es versteht sich, dass jeweils die weichste nicht vollständig relaxierte Schicht eine "Sollbruchstelle" ausbildet.

Ein weiterer Vorteil ist, dass sich mit der Einführung der ersten Schicht eine Verbiegung des Halbleitersubstrates durch die Einwirkung von kompressivem oder tensilem Stress verringert wird. Insbesondere bei dem Aufwachsen der weiteren Schichten bei der Epitaxie werden eine bessere Homogenität und eine bessere Reproduzierbarkeit des Schichtwachstums erreicht und sämtliche Schichten des Solarzellenstapels sind in situ herstellbar. Hierdurch lassen sich Halbleiter-Solarzellen mit sehr unterschiedlichen Gitterkonstanten bzw. Bandabstand, nachfolgend auch als Energie der Bandlücken bezeichnet, einfach und kostengünstig und mit hohem Wirkungsgrad in Rahmen eines Epitaxieprozesses aufeinander wachsen. Die Ausbildung von Fehlstellen oder Versetzungen wird zuverlässig von der "Sollbruchstelle" innerhalb des metamorphen Puffers erleichtert, was zur Relaxation des Halbleiter-Schichtstapels beiträgt, wobei durch den Verlauf des Härtegradienten gleichzeitig die Ausbreitung der Fehlstellen und Versetzungen in Bereiche außerhalb des metamorphen Puffers unterdrückt wird.

Ein anderer Vorteil ist, dass der Solarzellenstapel gemäß Gegenstand der Erfindung nach dessen Herstellung eine geringere Restspannung aufweist. Dies führt zu einer höheren Betriebssicherheit und höhere Wirkungsgraden bei den Solarzellenstapeln.

Ein weiterer Vorteil ist, dass sich mehrere Halbleiter-Solarzellen mit unterschiedlichen Gitterkonstanten und Bandlücken einfach derart zu dem Solarzellenstapel zusammenfügen lassen, dass sich der Gesamtwirkungsgrad des Solarzellenstapels erhöht.

In einer Weiterbildung nimmt bei der Abfolge von drei Schichten des metamorphen Puffers der In-Gehalt und die Gitterkonstante von einer Schicht zu einer nachfolgenden Schicht jeweils zu und der Al-Gehalt jeweils ab. Besonders bevorzugt ist, wenn zwischen wenigstens zwei Schichten des metamorphen Puffers der In-Gehalt um mindestens 1% zunimmt und der Al-Gehalt um mindestens 1% abnimmt.

In einer Weiterbildung weist die erste Schicht des metamorphen Puffers eine größere Gitterkonstante als die erste Halbleiter-Solarzelle auf. In einer bevorzugten Weiterbildung ist der Aluminiumgehalt der ersten Schicht größer als oder wenigstens gleich hoch wie der Aluminiumgehalt aller anderen Schichten des metamorphen Puffers. Untersuchungen haben gezeigt, dass sich die Versetzungen bevorzugt in der ersten weichsten Schicht des metamorphen Puffers ausbilden.

In einer bevorzugten Ausführungsform steigt die Gitterkonstante des metamorphen Puffers in Richtung der zweiten Halbleitersolarzelle von Schicht zu Schicht vorzugsweise um jeweils mindestens 0,003 Ä, höchstvorzugsweise um jeweils mindestens 0,005 Å an.

In einer Weiterbildung weist eine Schicht des metamorphen Puffers eine dritte Gitterkonstante auf. Die dritte Gitterkonstante ist größer als die Gitterkonstante der zweiten Halbleiter-Solarzelle. Untersuchungen haben gezeigt, dass sich hierdurch die Relaxation des metamorphen Puffers weiter verbessert lässt.

In einer bevorzugten Ausführungsform weist der metamorphe Puffer eine vierte Schicht oberhalb und stoffschlüssig verbunden mit der dritten Schicht auf. Die Gitterkonstante der vierten Schicht ist kleiner als die Gitterkonstante der dritten Schicht. In detaillierten Untersuchungen konnte gezeigt werden, dass die Verkrümmung der Wafer aufgrund des metamorphen Wachstums durch geeignete Wahl der Gitterkonstante und Schichtdicke der vierten Schicht weiter optimiert werden kann.

In einer besonders bevorzugten Ausführungsform sind innerhalb der Abfolge von Schichten des metamorphen Puffers nur AlInGaAs-Schichten oder nur AlInGaP-Schichten ausgebildet.

In einer Weiterbildung weist bei einer Abfolge von vier Schichten die erste Schicht eine kleinere Gitterkonstante und eine kleinere Nanohärte als die zweite Schicht auf und die dritte Schicht eine größere Gitterkonstante und eine größere Nanohärte als die zweite Schicht auf. Des Weiteren ist eine vierte Schicht vorgesehen und weist eine kleinere Gitterkonstante und eine kleinere Nanohärte als die dritte Schicht auf. Hierdurch wird die Relaxation der Gitterfehlanpassung der unterliegenden Schichten durch Bildung weiterer Fehlpassungsversetzungen verbessert. In einer bevorzugten Ausführungsform sind bei einer Abfolge von drei Schichten die erste Schicht mit der zweiten Schicht und die zweite Schicht mit der dritten Schicht stoffschlüssig verbunden.

In einer anderen Ausführungsform ist eine dritte Halbleiter-Solarzelle vorgesehen, wobei zwischen der zweiten Halbleiter-Solarzelle und der dritten Halbleiter-Solarzelle ein weiterer metamorpher Puffer ausgebildet ist. Anders ausgedrückt, in dem gesamten Solarzellenstapel sind zwei von räumlich mindesten durch eine Solarzelle von einander getrennte metamorphe Puffer ausgebildet. In einer andern Ausführungsform ist eine Abfolge von zwei metamorphen Puffern zwischen zwei Halbleiter-Solarzellen ausgebildet. Des Weiteren ist bevorzugt, dass jede der Halbleiter-Solarzelle einen pn-Übergang beinhaltet. Des Weiteren sei angemerkt, dass die metamorphen Pufferschichten nicht Teil eines pn-Übergangs einer Tunneldiode sind.

Die Erfindung wird nachfolgend unter Bezugnahme auf die Zeichnungen näher erläutert. Hierbei werden gleichartige Teile mit identischen Bezeichnungen beschriftet. Die dargestellten Ausführungsformen sind stark schematisiert, d.h. die Abstände sowie die lateralen und die vertikalen Erstreckungen sind nicht maßstäblich und weisen, sofern nicht anders angegeben, auch keine ableitbaren geometrischen Relationen zueinander auf. Es zeigt die:
- Figur 1: eine erste erfindungsgemäße Ausführungsform eines Solarzellenstapels mit einem metamorphen Puffer,
- Figur 2: Nanohärte in Abhängigkeit von der Gitterkonstante für verschiedene Stöchiometrien.
- Figur 3a: eine weitere Darstellung der Ausführungsform des Solarzellenstapels der Figur 1 mit einem metamorphen Puffer,
- Figur 3b: Darstellung eine anderen Ausführungsform des Solarzellenstapels der Figur 1 mit einem metamorphen Puffer,
- Figur 3c: eine weitere erfindungsgemäße Ausführungsform mit zwei metamorphen Puffern,
- Figur 4: eine Darstellung von metamorphen Puffern gemäß des Standes der Technik,
- Figur 5: eine Darstellung von metamorphen Puffern gemäß des Standes der Technik.

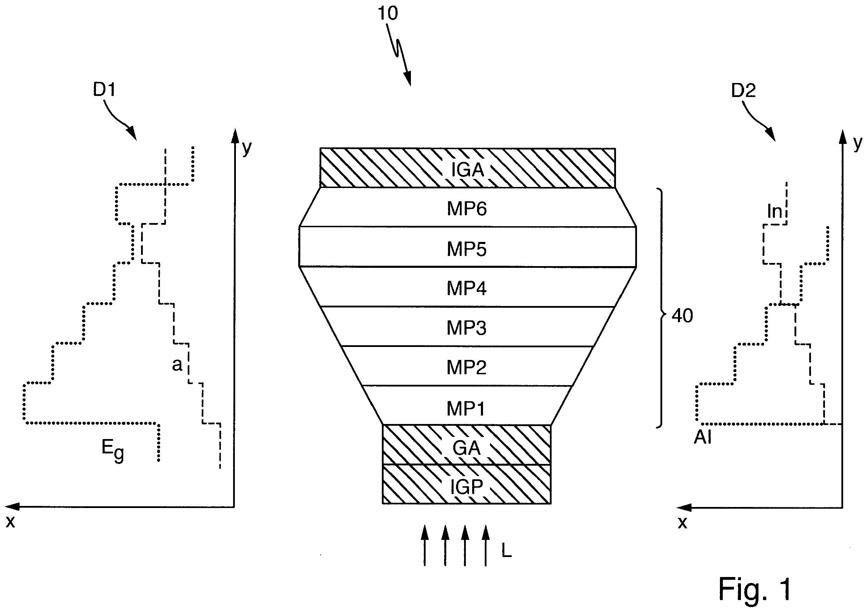

Die Abbildung der Figur 1 zeigt eine schematische Ansicht einer ersten Ausführungsform, aufweisend einen Solarzellenstapel 10 mit einer Halbleiter-Solarzelle IGP, wobei die Halbleiter-Solarzelle IGP einen p-n Übergang aus einem Material mit einer Gitterkonstanten aufweist, und mit einer ersten Halbleiter-Solarzelle GA, wobei die erste Halbleiter-Solarzelle GA einen p-n Übergang aus einem ersten Material mit einer ersten Gitterkonstanten aufweist, und mit einer zweite Halbleiter-Solarzelle IGA, wobei die zweite Halbleiter-Solarzelle IGA einen p-n Übergang aus einem zweiten Material mit einer zweiten Gitterkonstanten aufweist, und wobei die erste Gitterkonstante der zweiten Gitterkonstanten entspricht (gitterangepasst) und die dritte Gitterkonstante größer als die zweite Gitterkonstante ist. Zwischen der zweiten Halbleiter-Solarzelle GA und der dritten Halbleiter-Solarzelle IGA des Solarzellenstapels 10 ist ein metamorpher Puffer 40 ausgebildet, um zwischen den unterschiedlichen Gitterkonstanten der beiden Halbleiter-Solarzellen GA und IGA zu vermitteln. Der Lichteinfall L in den Solarzellenstapel 10 findet durch die Halbleiter-Solarzelle IGP statt. Es versteht sich, dass die Bezeichnungen der einzelnen Solarzellen GA, IGA, IGP auf die vorzugsweise verwendeten chemischen Stoffe hinweisen, d.h. GA steht für Gallium-Arsenid, IGA für Indium-Gallium-Arsenid und IGP für Indium- Gallium-Phosphid.

Bei der Darstellung der einzelnen Schichten des metamorphen Puffers 40 ist die dargestellte Breite der jeweiligen Schicht ein Maß für die in-plane Gitterkonstante a der jeweiligen Schicht. Bei den einzelnen Schichten ist die Gitterkonstante a teilweise als konstant als auch über die Dicke der Schicht als zunehmend oder als abnehmend dargestellt. Es versteht sich, dass an der Grenzfläche zwischen zwei Schichten die beiden in-plane Gitterkonstanten a, auch als laterale Gitterkonstante a bezeichnet, der aufeinandertreffenden Schichten etwa gleich sind.

Vorliegend besteht der metamorphe Puffer 40 aus insgesamt sechs einzelnen Schichten. Auf der ersten Solarzelle GA ist eine erste metamorphe Schicht MP1 des metamorphen Puffers 40 mit einer etwas größeren Gitterkonstante als die Gitterkonstante der ersten Solarzelle GA ausgebildet. Aufliegend auf der ersten Schicht MP1 ist eine zweite metamorphe Schicht MP2 mit einer etwas größeren Gitterkonstante als die Gitterkonstante der ersten metamorphen Schicht MP1 ausgebildet. Aufliegend auf der zweiten Schicht MP2 ist eine dritte metamorphe Schicht MP3 mit einer etwas größeren Gitterkonstante als die Gitterkonstante der zweiten metamorphen Schicht MP2 ausgebildet. Aufliegend auf der dritten Schicht MP3 ist eine vierte metamorphe Schicht MP4 mit einer etwas größeren Gitterkonstante als die Gitterkonstante der dritten metamorphen Schicht MP3 ausgebildet. Aufliegend auf der vierten Schicht MP4 ist eine fünfte metamorphe Schicht MP5 mit einer etwas größeren Gitterkonstante als die Gitterkonstante der vierten metamorphen Schicht MP4 ausgebildet. Aufliegend auf der fünften Schicht MP5 ist eine sechste metamorphe Schicht MP6 mit einer etwas kleineren Gitterkonstante als die Gitterkonstante der fünften metamorphen Schicht MP5 ausgebildet. Aufliegend auf der sechsten Schicht MP6 ist die zweite Solarzelle IGA ausgebildet.

Zur Verdeutlichung der erfindungsgemäßen Ausführungsform sind parallel zu dem Solarzellenstapel 10 in einem ersten Diagramm D1 und in einem zweiten Diagramm D2 ausgewählte physikalische Parameter für den Bereich des metamorphen Puffers 40 zwischen der ersten Halbleiter-Solarzelle GA und der zweiten Halbleiter-Solarzelle IGA aufgetragen. In dem ersten Diagramm D1 sind entlang der X-Achse die Größe der Gitterkonstante a - gestrichelter Verlauf - und die Größe der Bandlücke Eg - gepunkteter Verlauf - aufgetragen, während entlang der Y-Achse die Abfolge der einzelnen Schichten des Puffers 40 dargestellt ist. In dem zweiten Diagramm D2 sind entlang der X-Achse der Indium-Gehalt - gestrichelter Verlauf- und der Aluminium-Gehalt - gepunkteter Verlauf - von (In)GaP bzw. (AI)InGaAs aufgetragen, während entlang der Y-Achse ebenfalls die Abfolge der einzelnen Schichten des Puffers 40 abgebildet ist. In dem Diagramm D2 ist der jeweilige Verlauf der Gehalte von In und Al jeweils nur mit den chemischen Zeichen referenziert. Nachfolgend wird aus Gründen der Übersichtlichkeit nur der vollständige Namen der jeweiligen chemischen Elemente angegeben.

In dem ersten Diagramm D1 zeigt sich, dass die Gitterkonstante a beginnend von der ersten Halbleiter-Solarzelle GA bis zu der fünften metamorphen Schicht MP5 zunimmt und bei der sechsten metamorphen Schicht MP6 abnimmt, um dann bei der nachfolgenden zweiten Solarzelle IGA konstant zu bleiben. Aus Gründen der Übersichtlichkeit ist der Verlauf der unverspannten Gitterkonstante a stufenförmig dargestellt. Es sei jedoch angemerkt, dass sich die in-plane Gitterkonstante in den im Allgemeinen dünnen Schichten des Puffers nahezu kontinuierlich ändert. Als dünne Schichten werden vorliegend Schichten mit Dicken von kleiner als 600 nm bezeichnet. Im Unterschied zu den dem Verlauf der Gitterkonstante a steigt die Energie der Bandlücke Eg von der zweiten Solarzelle zu der ersten metamorphen Schicht MP1 sprunghaft an. Im Verlauf von der ersten metamorphen Schicht MP1 bis hin einschließlich der fünften metamorphen Schicht MP5 reduziert sich die Energie der Bandlücke Eg stufenförmig. Von der fünften metamorphen Schicht MP5 zur sechsten metamorphen Schicht MP6 steigt die Energie der Bandlücke Eg wieder an, um schließlich von der sechsten metamorphen Schicht MP6 hinzu der zweiten Solarzelle IGA unter das Niveau der ersten Solarzelle GA abzufallen.

In dem zweiten Diagramm D2 zeigt sich, dass die erste metamorphe Schicht MP1 im Vergleich zu den nachfolgenden Schichten MP2 bis MP6 den höchsten Aluminium Gehalt aufweist. Ausgehend von der ersten Schicht MP1 sinkt der Aluminiumgehalt der nachfolgenden Schichten MP2 bis MP6 stufenförmig, wobei die Schicht MP6 den geringsten Aluminiumgehalt aufweist.

Im Gegensatz zu dem Verlauf des Aluminiumgehaltes steigt der Indiumgehalt zwischen der ersten metamorphen Schicht MP1 bis einschließlich zu der fünften metamorphen Schicht MP5 stufenförmig an. Anschließend fällt ausgehend von der fünften metamorphen Schicht MP5 hin zu der sechsten metamorphen Schicht MP6 der Indiumgehalt wieder ab. Anders ausgedrückt weist die fünfte metamorphe Schicht MP5 den höchsten Indiumgehalt in dem metamorphen Puffer auf. Es sei auch hier angemerkt, dass aus Gründen der Übersichtlichkeit die einzelnen Kompositionen in den jeweiligen Schichten als homogen dargestellt sind. Es versteht sich jedoch, dass zumindest an den Grenzflächen zwischen zwei aufeinanderliegenden Schichten sich die Komposition quasi kontinuierlich ändern kann.

In der Abbildung der Figur 2 ist die Nanohärte NH über der Gitterkonstante a für verschiedene AlyInxGa1-x-yAs Verbindungshalbleiterkompositionen aufgetragen. Nachfolgend wird aus Gründen der Übersichtlichkeit nur die chemische formelmäßige Bezeichnung der Verbindungshalbleiterkompositionen angeführt.

Mit der durchgezognen Linie ist ein bekannter Verlauf, wie bereits in Beschreibungseinleitung referenziert, dargestellt. Ferner haben Untersuchungen gezeigt, Ergebnisse sind mit einer gestrichelten Linie dargestellt, dass, ausgehend von einer binären Verbindung AlAs über eine ternäre Verbindung aus Al1-xInxAs hin zu einer binaren Verbindung InAs, d.h. Al wird sukzessive durch In ersetzt, die Gitterkonstante a ausgehend vom binären AlAs ansteigt, während die Nanohärte NH bis zu einem In Gehalt von etwa 0.6 auf ein Minimum absinkt, bevor die Nanohärte NH mit weiter zunehmendem In-Gehalt wieder ansteigt, wobei letztlich das Element In das Element Al vollständig ersetzt ist. Nachteilig bei diesem Verlauf ist, dass die Nanohärte NH erst bei großen Gitterkonstanten a und bei sehr hohen In-Gehalten, oberhalb von 0,6 ansteigt. Ist die Gitterkonstante der dritten Solarzelle IGA vorliegend kleiner als die von Al0.4In0.6As, lässt sich nicht erreichen, dass in dem Puffer die Härte mit der Gitterkonstanten ansteigt.

Andere Untersuchungen, dargestellt mit einer strichpunktierten Linie, haben gezeigt, dass sich durch eine erfindungsgemäße Kombination der Elemente Al, In und Ga insbesondere für eine quaternäre Verbindung AlyInx-Ga1-x-yAs bereits für geringe In-Gehalte ein Ansteigen der Nanohärte NH mit der Gitterkonstanten a erzielen lässt. Hierzu wird insbesondere ausgehend von AlyGa1-yAs oder AlyInxGa1-x-yAs durch Ersetzen von Al durch In die Nanohärte erst gesenkt, bevor durch ein geeignetes Ersetzen von Al durch In und Ga die Nanohärte NH im Vergleich zu dem gestrichelten Verlauf bei wesentlich kleineren Gitterkonstanten a wieder ansteigt. Anders ausgedrückt lässt sich ein Ansteigen der Nanohärte NH mit der Gitterkonstante a nunmehr bei In-Gehalten weit unterhalb von 0.6 d.h. bei kleinen Gitterkonstanten erreichen.

Ein Vorteil ist, dass sich nahezu an beliebigen Stellen innerhalb des metamorphen Puffers einzelne Schichten mit einer im Vergleich zu einer unterliegenden Schicht höheren Nanohärte NH bei kleinen Gitterkonstanten a einfügen lassen, um hierdurch die Ausbreitung von Versetzungen und Relaxation zu beeinflussen. Bevorzugt hierbei ist, dass eine Relaxation in der weichen Schicht auftritt. Eine Ausbildung von zusätzlichen sogenannten Blocking-Schichten außerhalb des Metamorphen Puffers erübrigt sich.

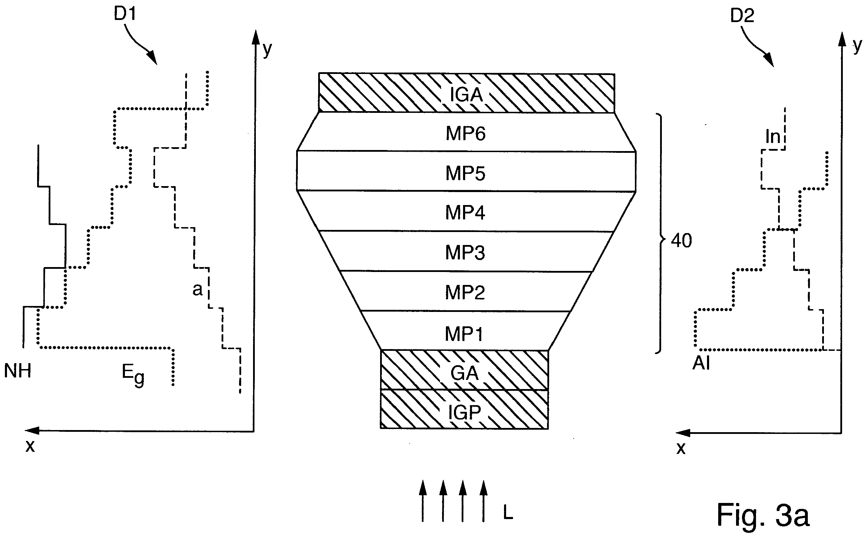

In der Abbildung der Figur 3a ist eine nochmalige Darstellung des Solarzellenstapels mit einer Abfolge von Schichten entsprechend der Figur 1 dargestellt. Nachfolgend werden nur die Unterschiede zu der Ausführungsform der Figur 1 erläutert. In dem Diagramm D1 ist der Verlauf der Nanohärte NH für die ersten fünf Schichten MP1 bis MP5 dargestellt. Hiernach ist die Nanohärte NH der ersten Schicht MP1 am Höchsten und sinkt stufenförmig bis zu einem Minimalwert in der dritten Schicht MP3 ab, um anschließend wieder stufenförmig bis zu der fünften Schicht MP5 trotz der weiter zunehmenden Gitterkonstante a anzusteigen. Hierdurch ist in der Mitte des Puffers 40 eine besonders weiche Schicht MP3 ausgebildet. Obwohl die Härte der Schicht MP5 niedriger sein kann als bei Schicht MP1, steigt die Härte des Puffers bei den Schichten MP3 bis MP5 bei größeren Gitterkonstanten an und unterdrückt die Ausbreitung von Versetzungen.

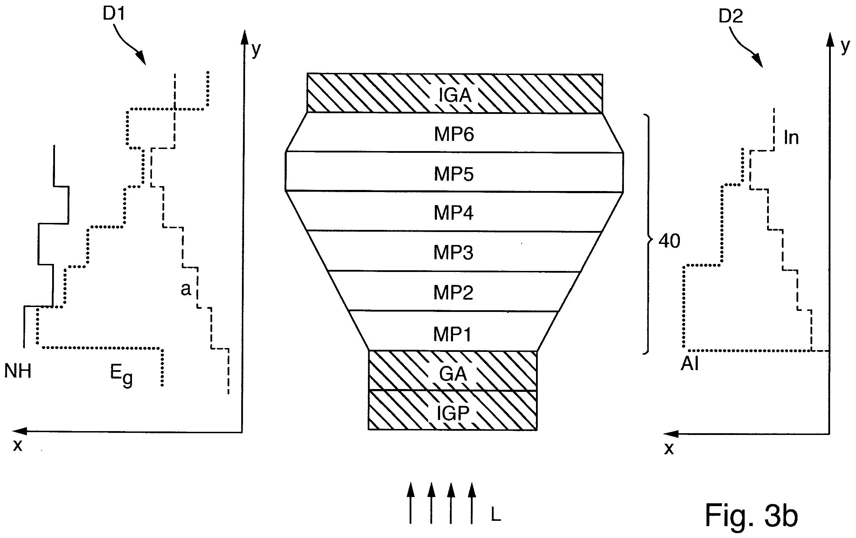

In der Abbildung der Figur 3b weitere Darstellung des Solarzellenstapels mit einer Abfolge von Schichten entsprechend der Figur 1 dargestellt. Nachfolgend werden nur die Unterschiede zu der Ausführungsform der Figur 1 erläutert. In dem Diagramm D2 ist der Verlauf des Aluminium Gehaltes der ersten fünf Pufferschichten MP1 bis MP5 dargestellt. Hierbei ist der Aluminium Gehalt der Schichten MP1 und MP2 gleich, sinkt aber beim Übergang zu der Schicht MP3 ab. Die Schichten MP3 und MP4 haben wieder den gleichen Aluminium Gehalt und Schicht MP5 einen noch niedrigeren Aluminium Gehalt. In dem Diagramm D1 ist der Verlauf der Nanohärte NH für die ersten fünf Schichten MP1 bis MP5 dargestellt. Hiernach ist die Nanohärte NH der ersten Schicht MP1 am Höchsten und sinkt stufenförmig zu zweiten Schicht MP2 ab, um wieder zu der dritten Schicht MP3 stufenförmig anzusteigen. Hierbei ist jedoch die Nanohärte NH der dritten Schicht MP3 kleiner, als die Nanohärte NH der ersten Schicht MP1. Ausgehend von der dritten Schicht MP3 sinkt die Nanohärte NH stufenförmig hin zu der vierten Schicht MP4 ab, wobei die Nanohärte NH der vierten Schicht MP4 jedoch geringer ist, als die Nanohärte NH der zweiten Schicht MP2. Ausgehend von der vierten Schicht MP4 steigt die Nanohärte NH stufenförmig zur fünften Schicht MP5 an, wobei die Nanohärte NH der fünften Schicht MP5 jedoch geringer ist, als die Nanohärte NH der dritten Schicht MP3 und geringer ist als die Nanohärte NH der ersten Schicht MP1.

Ein Vorteil der Ausbildung von mehreren Minima in Bezug auch die Nanohärten NH ist, dass eine Relaxation, sofern die Relaxation überhaupt auftritt, bevorzugt in den weichen Schichten innerhalb des Puffers ausbildet und eine Unterdrückung der Ausbreitung von Versetzungen in die Halbleiter-Solarzellen mittels den mehreren weichen Schichten des Puffers wirkungsvoll unterdrückt wird.

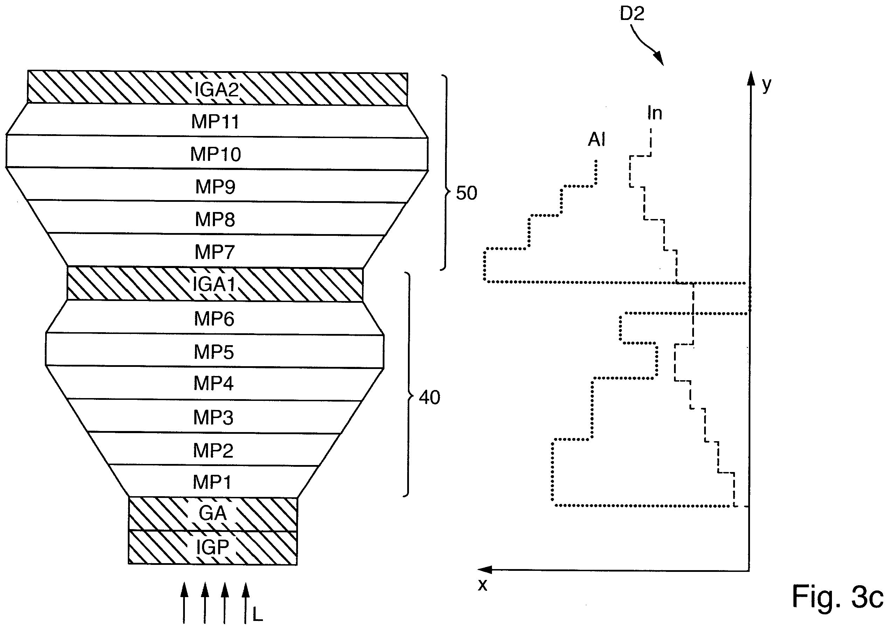

In der Abbildung der Figur 3c ist eine zweite erfindungsgemäße Ausführungsform mit einer Abfolge von zwei aufeinanderliegenden metamorphen Puffern, d.h. dem metamorphen Puffer 40 und einem weiteren metamorphen 50 dargestellt. Nachfolgend werden nur die Unterschiede zu der Ausführungsform abgebildet in Zusammenhang mit der Figur 1 erläutert. Auf der zweiten Solarzelle mit einer anderen oder auch gleichen zweiten Gitterkonstanten vorliegend mit IGA1 anstatt IGA bezeichnet, ist ein zweiter metamorpher Puffer 50 mit einer Abfolge von insgesamt fünf metamorphen Schichten ausgebildet, beginnend mit der siebten metamorphen Schicht MP7 bis einschließlich der elften metamorphen Schicht MP11. An die elfte metamorphe Schicht MP11 schließt sich eine dritte Solarzelle IGA2 an. Die Gitterkonstante a des zweiten metamorphen Puffers 50 ist im Mittel größer als die mittlere Gitterkonstante a des ersten Puffers 40. Es zeigt sich, dass der relative Verlauf der Gitterkonstante bei der Abfolge von den Schichten in dem jeweiligen Puffer vergleichbar ist, d. h. die zweitletzte Schicht des ersten Puffers 40 und die zweitletzte Schicht des zweiten metamorphen Puffers 50 weisen innerhalb des jeweiligen Puffers die größte Gitterkonstante a auf.

Aus Gründen der Übersichtlichkeit ist das erste Diagramm D1 für die beiden Puffer nicht abgebildet. In dem zweiten Diagramm D2 sind der Verlauf der Aluminiumkonzentration und der Verlauf der Indiumkonzentration für die beiden Puffer 40 und 50 dargestellt. Hiernach weist innerhalb des ersten Puffers 40 die erste Schicht MP1 und die zweite Schicht MP2 die gleiche und zugleich höchste Aluminiumkonzentration innerhalb des ersten Puffers 40 auf. Ausgehend von der zweiten Schicht MP2 sinkt die Aluminiumkonzentration hin zu der dritten Schicht MP3 und vierten Schicht MP4 stufenförmig ab, wobei die Aluminiumkonzentration in der dritten Schicht MP3 und in der vierten Schicht MP4 gleich ist. Ausgehend von der vierten Schicht MP4 sinkt die Aluminiumkonzentration hin zu der fünften Schicht MP5 stufenförmig und steigt hin zur sechsten Schicht MP6 wieder stufenförmig an. Hierbei ist die Aluminiumkonzentration der sechsten Schicht MP6 jedoch kleiner als die Aluminiumkonzentration der vierten Schicht MP4. Die zweiten Solarzelle IGA1 weist keine Aluminiumkonzentration auf.

In dem zweiten Puffer 50 weist die siebente Schicht MP7 die höchste Aluminiumkonzentration auf. Ausgehend von der siebenten Schicht MP7 sinkt die Aluminiumkonzentration von Schicht zu Schicht bis hin zu der zehnten Schicht stufenförmig ab.

Hinsichtlich der Indiumkonzentration ist in dem ersten Puffer 40, ausgehend von der ersten Schicht MP1 hin zu der fünften Schicht MP5 von Schicht zu Schicht ein stufenförmiger Anstieg ausgebildet. Ausgehend von der fünften Schicht MP5 hin zu der sechsten Schicht MP6 und der zweiten Halbleiter-Solarzelle MP6 sinkt die Indiumkonzentration stufenförmig in etwa auf die Konzentration der vierten Schicht MP4 ab, um im weiteren Verlauf der weiteren Abfolge der Schichten hin zu der siebenten Schicht MP7 in dem zweiten Puffer 50 erneut stufenförmig anzusteigen. Ausgehend von der siebenten Schicht MP7 hin zu der zehnten Schicht MP10 ist von Schicht zu Schicht ein stufenförmiger Anstieg in der Indiumkonzentration ausgebildet. Ausgehend von der zehnten Schicht MP10 hin zu der elften Schicht MP11 sinkt die Indiumkonzentration stufenförmig in etwa auf die Konzentration der neunten Schicht MP9 ab.

Es sei anmerkt, dass es bevorzugt ist, die in Zusammenhang mit der zweiten und dritten erfindungsgemäßen Ausführungsformen dargestellten Verläufe der Nanohärte NH auch in der vierten Ausführungsform auszubilden. Es versteht sich, dass sich die unterschiedlichen Ausbildungen des Verlaufs der Nanohärte NH auch kombinieren lassen.

Ein Vorteil ist, dass mit der Herstellung einer Abfolge von multiplen metamorphen Puffern sich ohne weiters größere Gitterunterschiede von einzelnen Halbleiter-Solarzellen, welche in Situ aufeinander gestapelt werden sollen, ausgleichen lassen. Hierbei lassen sich mögliche Versetzungen in dem weicheren Schichten der metamorphen Puffern 40 und 50 zuverlässig einfangen.

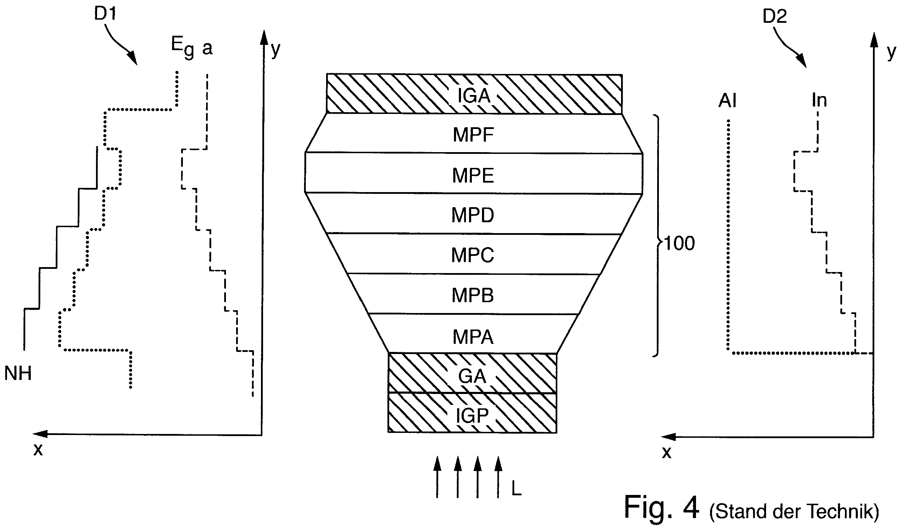

In der Figur 4 und der Figur 5 sind dem Stand der Technik gemäße Ausführungsformen eines metamorphen Puffers 100 mit dargestellt. Vorliegend besteht der metamorphe Puffer 100 ebenfalls aus sechs metamorphen Schichten MPA bis MPF. In beiden Figuren 4 und 5 sind aus Gründen der Übersichtlichkeit die Verläufe für die Gitterkonstanten a, bzw. die Bandlücke Eg, die Nanohärte NH für das jeweilige erste Diagramm D1 und die Verläufe der Aluminiumkonzentration und Indiumkonzentrationen für das jeweilige Diagramm D2 dargestellt. Im Folgenden werden nur die Unterschiede zu den erfindungsgemäßen Ausführungsformen erläutert.

Es zeigt sich für die Ausführungsform dargestellt in der Figur 4, dass gemäß dem ersten Diagramm D1 die Nanohärte NH stufenförmig ausgehend von der ersten Schicht MPA bis hin zu der fünften Schicht MPE des Puffers 100 abnimmt. In den zweiten Diagramm D2 ist die Aluminiumkonzentration innerhalb des Puffers 100 konstant. Diese Materialkombination wird nach dem Stand der Technik oft so gewählt, damit alle Pufferschichten eine ausreichende Transparenz aufweisen für Licht, welches in darunterliegenden Solarzellen noch zur photoelektrischen Energiekonversion genutzt werden kann. Für die Relaxation ist dies jedoch von Nachteil.

In der Figur 5 entspricht der Verlauf der Nanohärte NH der Ausführungsform in der Figur 4, während die die Aluminiumkonzentration innerhalb des Puffers 100 stufenförmig kontinuierlich ansteigt. Diese Materialkombination wird nach dem Stand der Technik oft so gewählt, damit alle Pufferschichten eine ausreichende Transparenz aufweisen für Licht, welches in darunterliegenden Solarzellen noch zur photoelektrischen Energiekonversion genutzt werden kann. AlInGaAs und AlInGaP Schichten mit kleineren In-Gehalten bzw. kleineren Gitterkonstanten sind in der Regel ohnehin transparenter als Schichten mit höherem In-Gehalt. Somit kann für Schichten mit kleinem In-Gehalt auch ein kleinerer Al-Gehalt gewählt werden, um ausreichende Transparenz zu gewährleisten. Auch dies ist jedoch für die Relaxation von Nachteil.

## Patentansprüche

1. Solarzellenstapel (10) aufweisend
- eine erste Halbleiter-Solarzelle (GA), wobei die erste Halbleiter-Solarzelle (GA) einen p-n Übergang aus einem ersten Material mit einer ersten Gitterkonstanten aufweist, und
- eine zweite Halbleiter-Solarzelle (IGA, IGA1), wobei die zweite Halbleiter-Solarzelle (IGA, IGA1) einen p-n Übergang aus einem zweiten Material mit einer zweiten Gitterkonstanten aufweist, und
- die erste Gitterkonstante kleiner als die zweite Gitterkonstante ist, und
- einen metamorphen Puffer (40), wobei der metamorphe Puffer (40) eine Abfolge von einer ersten unteren AlInGaAs- oder AlInGaP-Schicht und einer zweiten mittleren AlInGaAs- oder AlInGaP-Schicht und einer dritten oberen AlInGaAs- oder AlInGaP-Schicht umfasst, und der metamorphe Puffer (40) zwischen der ersten Halbleiter-Solarzelle (GA) und der zweiten Halbleiter-Solarzelle (IGA, IGA1) ausgebildet ist und bei dem metamorphe Puffer (40) sich entlang der Dickenerstreckung des metamorphen Puffers (40) die Gitterkonstante (a) ändert,
**dadurch gekennzeichnet, dass**
zwischen wenigstens zwei Schichten (MP1, MP2, MP3, MP4, MP5, MP6) des metamorphen Puffers (40) die Gitterkonstante (a) und der In-Gehalt zunimmt und der Al-Gehalt abnimmt.

2. Solarzellenstapel (10) nach Anspruch 1, **dadurch gekennzeichnet, dass** bei der Abfolge von drei Schichten (MP1, MP2, MP3, MP4, MP5, MP6) des metamorphen Puffers (40) der In-Gehalt und die Gitterkonstante (a) von einer Schicht (MP1, MP2, MP3, MP4, MP5, MP6) zu einer nachfolgenden Schicht (MP1, MP2, MP3, MP4, MP5, MP6) jeweils zunimmt und der Al-Gehalt jeweils abnimmt.

3. Solarzellenstapel (10) nach einem der vorangegangenen Ansprüche, **dadurch gekennzeichnet, dass** zwischen wenigstens zwei Schichten (MP1, MP2, MP3, MP4, MP5, MP6) des metamorphen Puffers (40) der In-Gehalt um mindestens 1% zunimmt und der Al-Gehalt um mindestens 1% abnimmt.

4. Solarzellenstapel (10) nach einem der vorangegangenen Ansprüche, **dadurch gekennzeichnet, dass** die Gitterkonstante des metamorphen Puffers in Richtung der zweiten Halbleitersolarzelle (IGA) von Schicht zu Schicht um jeweils mindestens 0,003 Ä ansteigt.

5. Solarzellenstapel (10) nach einem der vorangegangenen Ansprüche, **dadurch gekennzeichnet, dass** die Gitterkonstante des metamorphen Puffers in Richtung der zweiten Halbleitersolarzelle (IGA) von Schicht zu Schicht vorzugsweise um jeweils mindestens 0,005 Å ansteigt.

6. Solarzellenstapel (10) nach einem der vorangegangenen Ansprüche, **dadurch gekennzeichnet, dass** eine Schicht des metamorphen Puffers eine dritte Gitterkonstante aufweist und die dritte Gitterkonstante größer ist als die Gitterkonstante der zweiten Halbleiter-Solarzelle (IGA).

7. Solarzellenstapel (10) nach einem der vorangegangenen Ansprüche, **dadurch gekennzeichnet, dass** innerhalb der Abfolge von drei Schichten (MP1, MP2, MP3, MP4, MP5, MP6) des metamorphen Puffers (40) nur AlInGaAs-Schichten oder nur AlInGaP-Schichten ausgebildet sind.

8. Solarzellenstapel (10) nach einem der vorangegangenen Ansprüche, **dadurch gekennzeichnet, dass** bei einer Abfolge von drei Schichten (MP1, MP2, MP3, MP4, MP5, MP6) die erste Schicht (MP1, MP2, MP3, MP4, MP5, MP6) eine kleinere Gitterkonstante (a) und eine kleinere Nanohärte (NH) als die zweite Schicht (MP1, MP2, MP3, MP4, MP5, MP6) und die zweite Schicht (MP1, MP2, MP3, MP4, MP5, MP6) eine kleinere Gitterkonstante (a) und eine kleinere Nanohärte (NH) als die dritte Schicht (MP1, MP2, MP3, MP4, MP5, MP6) aufweist.

9. Solarzellenstapel (10) nach einem der vorangegangenen Ansprüche, **dadurch gekennzeichnet, dass** bei einer Abfolge von Schichten (MP1, MP2, MP3, MP4, MP5, MP6) die erste Schicht (MP1, MP2, MP3, MP4, MP5, MP6) der Abfolge eine größere Gitterkonstante (a) als die erste Halbleiter-Solarzelle (20) aufweist.

10. Solarzellenstapel (10) nach einem der vorangegangenen Ansprüche, **dadurch gekennzeichnet, dass** bei einer Abfolge von vier Schichten (MP1, MP2, MP3, MP4, MP5, MP6) eine vierte Schicht (MP1, MP2, MP3, MP4, MP5, MP6) vorgesehen ist und die vierte Schicht (MP1, MP2, MP3, MP4, MP5, MP6) oberhalb der dritten Schicht (MP1, MP2, MP3, MP4, MP5, MP6) angeordnet und stoffschlüssig mit der dritten Schicht (MP1, MP2, MP3, MP4, MP5, MP6) verbunden ist und die vierte Schicht (MP1, MP2, MP3, MP4, MP5, MP6) eine kleinere Gitterkonstante (a) als die dritte Schicht (MP1, MP2, MP3, MP4, MP5, MP6) aufweist.

11. Solarzellenstapel (10) nach einem der vorangegangenen Ansprüche, **dadurch gekennzeichnet, dass** bei einer Abfolge von drei Schichten, die erste Schicht (MP1, MP2, MP3, MP4, MP5, MP6) mit der zweiten Schicht (MP1, MP2, MP3, MP4, MP5, MP6) und die zweite Schicht (MP1, MP2, MP3, MP4, MP5, MP6) mit der dritten Schicht (MP1, MP2, MP3, MP4, MP5, MP6) stoffschlüssig verbunden ist.

12. Solarzellenstapel (10) nach einem der vorangegangenen Ansprüche, **dadurch gekennzeichnet, dass** eine dritte Halbleiter-Solarzelle vorgesehen ist und zwischen der zweiten Halbleiter-Solarzelle (IGA, IGA1) und der dritten Halbleiter-Solarzelle ein weiterer metamorpher Puffer (IGA2) ausgebildet ist oder zwischen der ersten Halbleiter-Solarzelle (GA) vorgesehen ist und zwischen der zweiten Halbleiter-Solarzelle (IGA, IGA1) der metamorphe Puffer (40) und der weitere metamorphe Puffer (50) angeordnet sind.

13. Solarzellenstapel (10) nach einem der vorangegangenen Ansprüche, **dadurch gekennzeichnet, dass** jede der Halbleiter-Solarzellen (IGP, GA, IGA, IGA1, IGA2) einen pn-Übergang beinhaltet.

14. Solarzellenstapel (10) nach einem der vorangegangenen Ansprüche, **dadurch gekennzeichnet, dass** die metamorphen Pufferschichten (MP1, MP2, MP3, MP4, MP5, MP6) nicht Teil eines pn-Übergangs einer Tunneldiode sind.

## Claims

1. Solar cell stack (10) comprising
- a first semiconductor solar cell (GA), wherein the first semiconductor solar cell (GA) has a p-n transition of a first material with a first lattice constant and
- a second semiconductor solar cell (IGA, IGA1), wherein the second semiconductor solar cell (IGA, IGA1) has a p-n transition of a second material with a second lattice constant and
- the first lattice constant is smaller than the second lattice constant and
- a metamorphic buffer (40), wherein the metamorphic buffer (40) comprises a sequence of a first, lower AlInGaAs layer or AlInGaP layer and a second, middle AlInGaAs layer or AlInGaP layer and a third, upper AlInGaAs layer or AlInGaP layer, and the metamorphic buffer (40) is formed between the first semiconductor solar cell (GA) and the second semiconductor solar cell (IGA, IGA1) and in the metamorphic buffer (40) the lattice constant (a) changes along the thickness dimension of the metamorphic buffer (40),
**characterised in that**
between at least two layers (MP1, MP2, MP3, MP4, MP5, MP6) of the metamorphic buffer (40) the lattice constant (a) and the In content increase and the Al content decreases.

2. Solar cell stack (10) according to claim 1, **characterised in that** in the sequence of three layers (MP1, MP2, MP3, MP4, MP5, MP6) of the metamorphic buffer (40) the In content and the lattice constant (a) increase each time from one layer (MP1, MP2, MP3, MP4, MP5, MP6) to a succeeding layer (MP1, MP2, MP3, MP4, MP5, MP6) and the Al content decreases each time.

3. Solar cell stack (10) according to any one of the preceding claims, **characterised in that** between at least two layers (MP1, MP2, MP3, MP4, MP5, MP6) of the metamorphic buffer (40) the In content increases by at least 1% and the Al content decreases by at least 1%.

4. Solar cell stack (10) according to any one of the preceding claims, **characterised in that** the lattice constant of the metamorphic buffer (40) increases in the direction of the second semiconductor solar cell (IGA) from layer to layer each time by at least 0.003 Å.

5. Solar cell stack (10) according to any one of the preceding claims, **characterised in that** the lattice constant of the metamorphic buffer increases in the direction of the second semiconductor solar cell (IGA) from layer to layer preferably each time by at least 0.005 Å.

6. Solar cell stack (10) according to any one of the preceding claims, **characterised in that** a layer of the metamorphic buffer has a third lattice constant and the third lattice constant is greater than the lattice constant of the second semiconductor solar cell (IGA).

7. Solar cell stack (10) according to any one of the preceding claims, **characterised in that** only AlInGaAs layers or only AlInGaP layers are formed within the sequence of three layers (MP1, MP2, MP3, MP4, MP5, MP6) of the metamorphic buffer (40).

8. Solar cell stack (10) according to any one of the preceding claims, **characterised in that** in a sequence of three layers (MP1, MP2, MP3, MP4, MP5, MP6) the first layer (MP1, MP2, MP3, MP4, MP5, MP6) has a smaller lattice constant (a) and a smaller nano-hardness (NH) than the second layer (MP1, MP2, MP3, MP4, MP5, MP6) and the second layer (MP1, MP2, MP3, MP4, MP5, MP6) has a smaller lattice constant (a) and a smaller nano-hardness (NH) than the third layer (MP1, MP2, MP3, MP4, MP5, MP6).

9. Solar cell stack (10) according to any one of the preceding claims, **characterised in that** in a sequence of layers (MP1, MP2, MP3, MP4, MP5, MP6) the first layer (MP1, MP2, MP3, MP4, MP5, MP6) of the sequence has a greater lattice constant (a) than the first semiconductor solar cell (20).

10. Solar cell stack (10) according to any one of the preceding claims, **characterised in that** in a sequence of four layers (MP1, MP2, MP3, MP4, MP5, MP6) a fourth layer (MP1, MP2, MP3, MP4, MP5, MP6) is provided and the fourth layer (MP1, MP2, MP3, MP4, MP5, MP6) is arranged above the third layer (MP1, MP2, MP3, MP4, MP5, MP6) and connected by material couple with the third layer (MP1, MP2, MP3, MP4, MP5, MP6) and the fourth layer (MP1, MP2, MP3, MP4, MP5, MP6) has a smaller lattice constant (a) than the third layer (MP1, MP2, MP3, MP4, MP5, MP6).

11. Solar cell stack (10) according to any one of the preceding claims, **characterised in that** in a sequence of three layers, the first layer (MP1, MP2, MP3, MP4, MP5, MP6) is connected by material couple with the second layer (MP1, MP2, MP3, MP4, MP5, MP6) and the second layer (MP1, MP2, MP3, MP4, MP5, MP6) is connected by material couple with the third layer (MP1, MP2, MP3, MP4, MP5, MP6).

12. Solar cell stack (10) according to any one of the preceding claims, **characterised in that** a third semiconductor solar cell is provided and a further metamorphic buffer (IGA2) is formed between the second semiconductor solar cell (IGA, IGA1) and the third semiconductor solar cell or is provided between the first semiconductor solar cell (GA) and the metamorphic buffer (40) and the further metamorphic buffer (50) are arranged between the second semiconductor solar cell (IGA, IGA1).

13. Solar cell stack (10) according to any one of the preceding claims, **characterised in that** each of the semiconductor cells (IGP, GA, IGA, IGA1, IGA2) includes a p-n transition.

14. Solar cell stack (10) according to any one of the preceding claims, **characterised in that** the metamorphic buffer layers (MP1, MP2, MP3, MP4, MP5, MP6) are not a part of a p-n transition of a tunnel diode.

## Revendications

1. Empilement de cellules solaires (10) présentant
- une première cellule solaire à semi-conducteur (GA), dans lequel la première cellule solaire à semi-conducteur (GA) présente une transition p-n en un premier matériau avec une première constante de réseau et
- une deuxième cellule solaire à semi-conducteur (IGA, IGA1), dans lequel la deuxième cellule solaire à semi-conducteur (IGA, IGA1) présente une transition p-n en un deuxième matériau avec une deuxième constante de réseau, et
- la première constante de réseau est plus petite que la deuxième constante de réseau, et
- un tampon métamorphe (40), dans lequel le tampon métamorphe (40) comprend une succession d'une première couche inférieure de AlInGaAs ou AlInGaP et d'une deuxième couche moyenne de AlInGaAs ou AlInGaP et d'une troisième couche supérieure de AlInGaAs ou AlInGaP et le tampon métamorphe (40) est formé entre la première cellule solaire à semi-conducteur (GA) et la deuxième cellule solaire à semi-conducteur (IGA, IGA1) et la constante de réseau (a) varie dans le tampon métamorphe (40) le long de la dimension d'épaisseur du tampon métamorphe (40),
**caractérisé en ce que** la constante de réseau (a) et la teneur en In augmentent et la teneur en Al diminue entre au moins deux couches (MP1, MP2, MP3, MP4, MP5, MP6) du tampon métamorphe (40).

2. Empilement de cellules solaires (10) selon la revendication 1, **caractérisé en ce que**, dans le cas de la succession de trois couches (MP1, MP2, MP3, MP4, MP5, MP6) du tampon métamorphe (40), la teneur en In et la constante de réseau (a) augmentent chaque fois d'une couche (MP1, MP2, MP3, MP4, MP5, MP6) à une couche (MP1, MP2, MP3, MP4, MP5, MP6) suivante et la teneur en Al diminue chaque fois.

3. Empilement de cellules solaires (10) selon l'une quelconque des revendications précédentes, **caractérisé en ce que** la teneur en In augmente d'au moins 1 % et la teneur en Al diminue d'au moins 1 % entre au moins deux couches (MP1, MP2, MP3, MP4, MP5, MP6) du tampon métamorphe (40).

4. Empilement de cellules solaires (10) selon l'une quelconque des revendications précédentes, **caractérisé en ce que** la constante de réseau du tampon métamorphe augmente de couche en couche d'au moins chaque fois 0,003 Å en direction de la deuxième cellule solaire à semi-conducteur (IGA).

5. Empilement de cellules solaires (10) selon l'une quelconque des revendications précédentes, **caractérisé en ce que** la constante de réseau du tampon métamorphe augmente de couche en couche de préférence d'au moins 0,005 Å en direction de la deuxième cellule solaire à semi-conducteur (IGA).

6. Empilement de cellules solaires (10) selon l'une quelconque des revendications précédentes, **caractérisé en ce qu'**une couche du tampon métamorphe présente une troisième constante de réseau et la troisième constante de réseau est plus grande que la constante de réseau de la deuxième cellule solaire à semi-conducteur (IGA).

7. Empilement de cellules solaires (10) selon l'une quelconque des revendications précédentes, **caractérisé en ce que** seules des couches de AlInGaAs ou seules des couches de AlInGaP sont formées à l'intérieur de la succession de trois couches (MP1, MP2, MP3, MP4, MP5, MP6) du tampon métamorphe (40).

8. Empilement de cellules solaires (10) selon l'une quelconque des revendications précédentes, **caractérisé en ce que**, dans le cas d'une succession de trois couches (MP1, MP2, MP3, MP4, MP5, MP6), la première couche (MP1, MP2, MP3, MP4, MP5, MP6) présente une plus petite constante de réseau (a) et une plus petite nanodureté (NH) que la deuxième couche (MP1, MP2, MP3, MP4, MP5, MP6) et la deuxième couche (MP1, MP2, MP3, MP4, MP5, MP6) présente une plus petite constante de réseau (a) et une plus petite nanodureté (NH) que la troisième couche (MP1, MP2, MP3, MP4, MP5, MP6).

9. Empilement de cellules solaires (10) selon l'une quelconque des revendications précédentes, **caractérisé en ce que**, dans le cas d'une succession de couches (MP1, MP2, MP3, MP4, MP5, MP6), la première couche (MP1, MP2, MP3, MP4, MP5, MP6) de la succession présente une plus grande constante de réseau (a) que la première cellule solaire à semi-conducteur (20).

10. Empilement de cellules solaires (10) selon l'une quelconque des revendications précédentes, **caractérisé en ce que**, dans le cas d'une succession de quatre couches (MP1, MP2, MP3, MP4, MP5, MP6), il est prévu une quatrième couche (MP1, MP2, MP3, MP4, MP5, MP6) et la quatrième couche (MP1, MP2, MP3, MP4, MP5, MP6) est disposée au-dessus de la troisième couche (MP1, MP2, MP3, MP4, MP5, MP6) et est liée matériellement à la troisième couche (MP1, MP2, MP3, MP4, MP5, MP6) et la quatrième couche (MP1, MP2, MP3, MP4, MP5, MP6) présente une plus petite constante de réseau (a) que la troisième couche (MP1, MP2, MP3, MP4, MP5, MP6).

11. Empilement de cellules solaires (10) selon l'une quelconque des revendications précédentes, **caractérisé en ce que** dans le cas d'une succession de trois couches, la première couche (MP1, MP2, MP3, MP4, MP5, MP6) est liée matériellement à la deuxième couche (MP1, MP2, MP3, MP4, MP5, MP6) et la deuxième couche (MP1, MP2, MP3, MP4, MP5, MP6) est liée matériellement à la troisième couche (MP1, MP2, MP3, MP4, MP5, MP6).

12. Empilement de cellules solaires (10) selon l'une quelconque des revendications précédentes, **caractérisé en ce qu'**il est prévu une troisième cellule solaire à semi-conducteur et un autre tampon métamorphe (50) est formé entre la deuxième cellule solaire à semi-conducteur (IGA, IGA1) et la troisième cellule solaire à semi-conducteur ou entre la première cellule solaire à semi-conducteur (GA) et la deuxième cellule solaire à semi-conducteur (IGA1), sont disposés le tampon métamorphe (40) et l'autre tampon métamorphe (50).

13. Empilement de cellules solaires (10) selon l'une quelconque des revendications précédentes, **caractérisé en ce que** chacune des cellules solaires à semi-conducteur (IGP, GA, IGA, IGA1, IGA2) contient une transition pn.

14. Empilement de cellules solaires (10) selon l'une quelconque des revendications précédentes, **caractérisé en ce que** les couches tampons métamorphes (MP1, MP2, MP3, MP4, MP5, MP6) ne font pas partie d'une transition pn d'une diode tunnel.
